# EUROPEAN PATENT SPECIFICATION

(11) **EP 2 592 646 B1**
(45) Date of publication and mention of the grant of the patent: **23.09.2020**
(21) Application number: 12192364.3
(22) Date of filing: 13.11.2012
(51) Int. Cl.: H01L 21/67

(54) **Etching Apparatus and Methods**
Ätzvorrichtung und -verfahren
Appareil et procédé de gravure

(30) Priority: 14.11.2011 GB 201119598
(43) Date of publication of application: 15.05.2013
(73) Proprietor: SPTS Technologies Limited, Newport Gwent NP18 2TA (GB)
(72) Inventor: Ansell, OliverJames, Long Ashton, Bristol, (GB)
(74) Representative: Wynne-Jones IP Limited

(56) References cited:
- JP-A- S62 171 127
- US-A1- 2005 042 777
- US-A1- 2011 054 659

## Description

This invention relates to apparatus and methods for uniformly removing material across the whole width of a substrate by plasma etching to expose the ends of buried, filled vias or other buried features.

The problem of end point detection is well known in the plasma etch industry and various techniques have been developed to detect the point at which a substrate has been etched to the desired depth, so that the etch process can be halted. In typical applications, features are etched through a mask layer into the underlying layer or layers. The detection of the end point (the reaching of the desired etch depth) tends to be based on two distinct technologies. In one, the apparatus or operator is looking for a change in chemistry at the point at which the etch breaks through from one layer to another. This may arise from a change in the chemistry of the actual layers built up in the device or thin etch stop layer may be deliberately deposited between two layers so as to induce a change in chemistry. In early days the etch was simply carried on for a fixed time. More sophisticated and faster techniques have been developed over the years. The second technique is based on reflectometry or interferometry which rely on the upper surface of the substrate (e.g. the hard mask) forming a reference surface against which the depth of the etched structure may be judged.

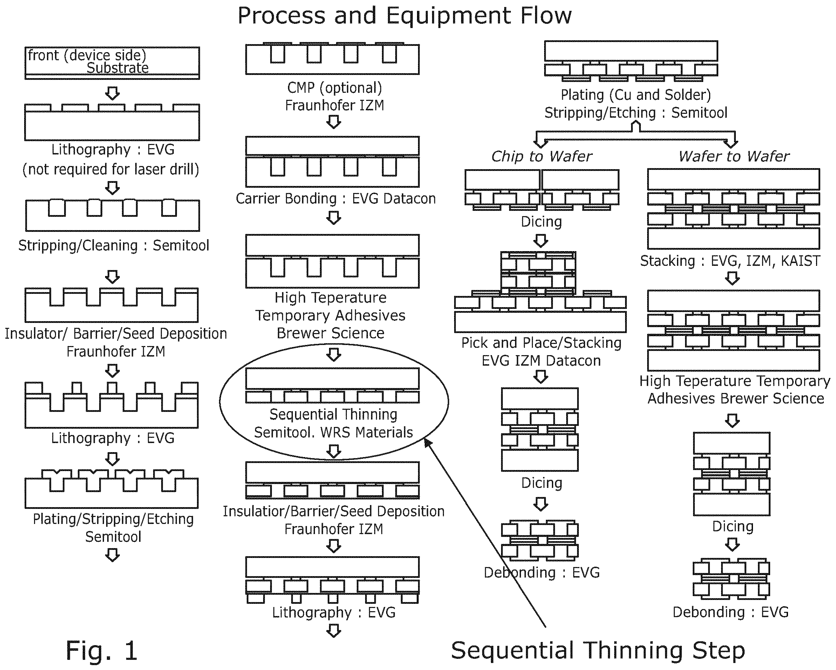

Recently, 3-D device integration schemes have started to produce new challenges for process equipment. A possible process and equipment flow is shown in Figure 1, which is Figure EP17 from the assembly and packaging section of the 2009 edition of the ITRS (International Technology Roadmap for Semiconductors). This illustrates the progressive development of the device and, in the highlighted part of the sequence, calls for sequential thinning. In this step a device in which filled vias had been formed is inverted so that the backside of the substrate can be removed down to the level of the tops of the filled vias or other buried feature.

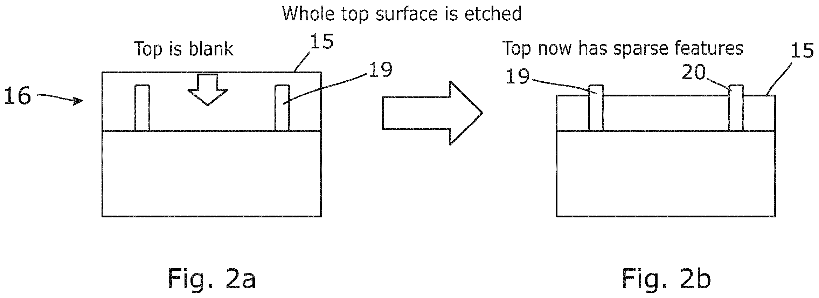

Traditionally, this might all have been done by chemical mechanical polishing but there are advantages in performing the later stages of the step using a plasma etch process. US-B2-7416648 is an example of such a process. However, because the substrate is etched across its width, there is no reference surface by means of which reflectometry or interferometry could be used. Equally, the buried features are so small (typically 10µm diameter), and form such a small part of the total area of the etch face, that any change in chemistry is too small to detect. The whole top surface etching process is schematically illustrated in Figure 2. If the thickness of material above the buried features is significant, then it may be convenient to use chemical mechanical polishing until quite close to the expected positions of the tips of the buried features, e.g. within 10µm and then to etch. Figure 1(a) is illustrative of a pre-etch situation.

US patent application US2005/042777 discloses apparatus and methods relating to the control of etch and deposition processes in the manufacture of semiconductor devices, microelectronic machines and waveguides.

JP S62 171127 A discloses [ABSTRACT]: "To detect the end point of etching with high sensitivity and accuracy, by utilizing a phenomenon that an amount of regulator reflection of unidirectional light applied onto the surface of a substance to be etched is varied by the height of a step of the surface of the substance to be etched."

From one aspect the invention consists in a method of etching the whole width of a substrate, typically in the absence of a masking layer, to expose the ends of features buried in the substrate, e.g. filled vias, including:
(a) etching the face of a substrate across its width to achieve substantially uniform removal of material;
(b) illuminating the etched face during the etch process;
(c) detecting non-homogeneity in an image of the face represented by light reflected or scattered from the face to detect the exposure of the buried features; and
(d) modifying the etch in response to the detecting of the buried features.

Step (c) may include applying edge detection techniques to light reflected or scattered from the face to detect the appearance of the buried features

It will be understood that in each of these processes the problems of the lack of reference surface and the lack of significant plasma chemistry change have been overcome.

The step of modifying the etch includes changing the process conditions or stopping the etch.

It is particularly preferred that the etch face is illuminated at an acute angle and in either case step (c) may include using a camera to capture the reflected or scattered light for producing an output signal and an edge detector filter for detecting the appearance of edges from the camera output signal.

The camera may be positioned for receiving light reflected or scattered at an acute angle.

The edge detector filter may be a Sobel filter.

From a further aspect the invention consists in etching apparatus for etching a substrate across its width to expose features buried in the substrate, (e.g. filled vias) including:
(a) an etch chamber for etching a substrate;
(b) a substrate comprising buried features
(c) a support for a substrate for retaining the substrate in a generally horizontal position with a face to be etched exposed;
(d) an illumination source mounted at an acute angle with respect to the support for illuminating the face;
(e) a camera for capturing light reflected or scattered from the face at an acute angle;
(f) an edge detector coupled to the camera for detecting the appearance of at least one edge on the face; and
(g) a controller for controlling the etch operation of the chamber and stopping the etch in response to the detection of an edge.

The edge detector may utilise a Sobel filter.

It will be understood that the edge detector could be replaced by any suitable non-homogeneity detector for detecting non-homogeneity in the appearance of the face. However due to the orthogonal arrangement used in the lay-out of vias on a wafer the use of a Sobel filter or filters is particularly useful for edge detection.

Although the invention has been defined above it is to be understood it includes any inventive combination of the features set out above or in the following description.

The invention may be performed in various ways and is a specific embodiment will now be described, by way of example, with reference to the accompanying drawings, in which:
Figure 1 is a process and equipment flow as described above;
Figure 2 is a schematic diagram showing the etch process to be performed;
Figure 3(a) is an original image from a camera of the Applicants' apparatus showing a surface in which buried features have been exposed, Figure 3(b) shows the surface image after etching, Figure 3(c) shows the image after Sobel edge filter has been applied and Figure 3(d) shows the change in intensity signal of the vertical edge detection as a function of etch time;
Figures 4(a) and (b) are schematic plan and side views of an apparatus illustrating possible illumination and camera positions;
Figures 5(a) and (b) show processed images from reflected light and scattered light respectively;
Figure 6 is a schematic flow diagram of an embodiment of the Applicants' process;
Figure 7 shows the average intensity in the region of interest on the face during the process for the output of the Sobel filter; and
Figures 8(a), (b) and (c) are respectively a processed image before the end point, a processed image after the end point and a raw image after the end point.

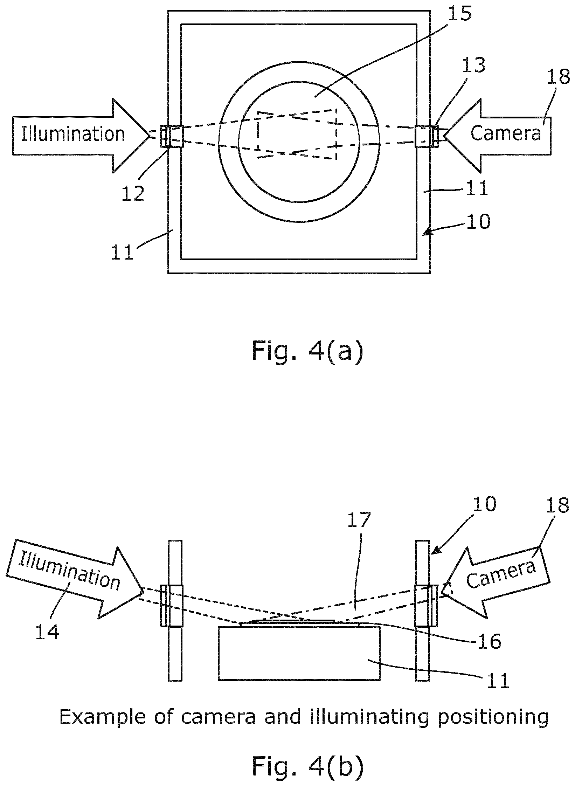

Figures 4 (a) and (b) show, schematically, a part of an etch chamber 10, which encloses a substrate support 11. The construction and operation of such chambers is well known to persons skilled in the art and will not be described here other than is necessary for an understanding of the invention.

Windows 12, 13 are formed in respective opposed walls 11 of the chamber 10. An illumination source 14 illuminates a part of the surface of an exposed face 15 of the substrate 16. Scattered radiation 17 passes to a camera 18 through the window 13 and is detected by the camera 18.

There are a large number of image detection techniques which could be used to distinguish successive images detected by the camera to determine the change of the face 15 from a homogeneous face to non-homogeneous face, as a result of the appearance of the upper surfaces of buried features. For simplicity these features will be treated as being filled vias for the rest of this description. These are for example illustrated at 19 in Figures 2(a) and (b). However, in a number of such detection techniques the pixel size of the camera would need to be less than the surface area of the exposed buried feature. As the buried features are typically 10µm in diameter this is technologically demanding and requires an extremely expensive camera. Accordingly, in particular embodiments the Applicants have appreciated that they can avoid the need for this pixel size limitation by using edge detection techniques, such as a Sobel filter.

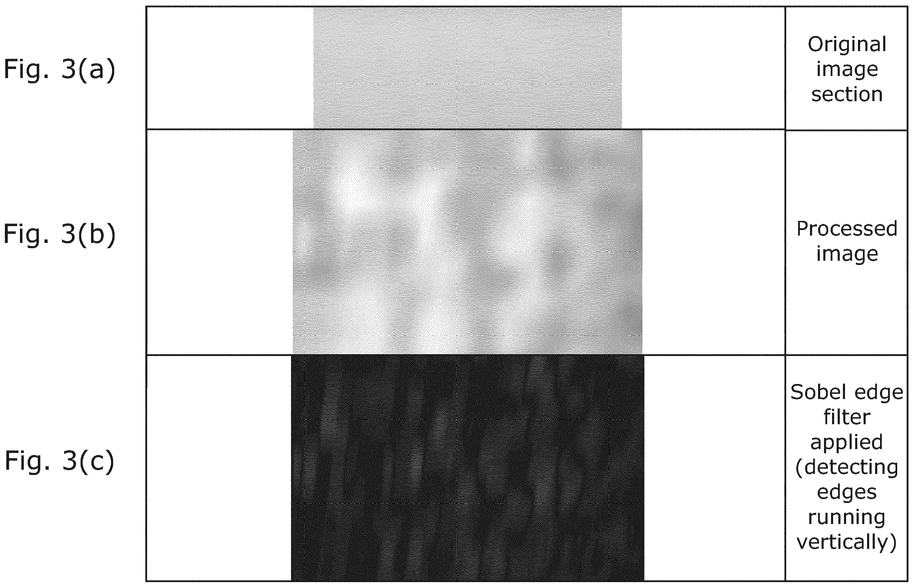

The advantages of this can be seen in Figures 3(a) to (d). At Figure 3(a) the basic image of the illuminated section of the face 15 is shown. Figure 3(b) shows an image of an etched feature which has been enlarged and contrast enhanced. Figure 3(c) illustrates the image after it has been processed by a Sobel edge filter. It will be apparent that the detected vias are now significantly more visible and the resultant change in intensity in the Sobel filter is enhanced because the buried features are aligned.

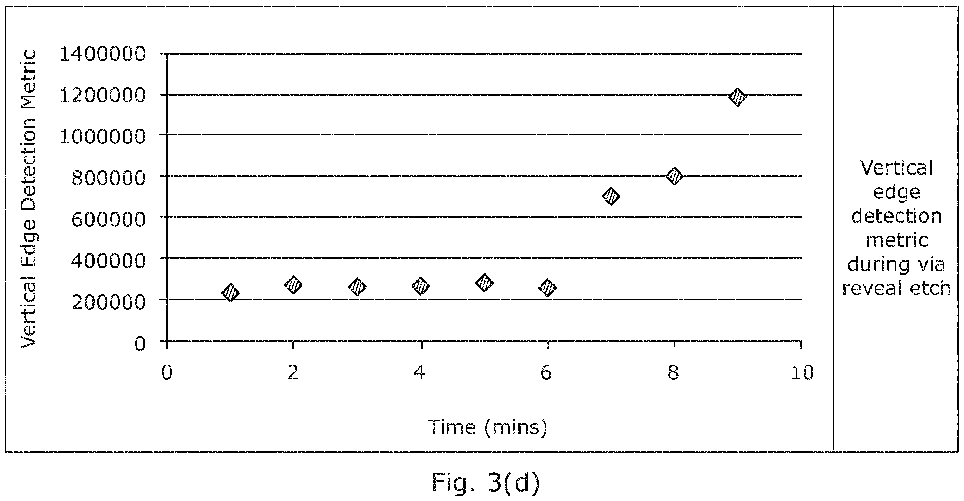

Sobel filters are well known in the art but for ease of understanding of the present invention they utilise a Sobel operator which is a discrete differentiation operator, computing an approximation of the gradient of the image intensity function. In practice they apply to sequence a vertical and horizontal filter to an image. The intensities of the images are then processed to enhance the appearance of the edges of the features in the image. Preferably this sequence is carried out throughout the etch process. This is illustrated for the region of the wafer for which the images in Figure 3(a)-3(c) are taken by the graph shown in Figure 3(d). The section for the first six minutes of etch shows no significant change in intensity of the vertical edge detection signal because the surface is homogeneous and then after six minutes the graph rises due to the appearance of buried features creating changes in the intensity gradient in the image. This change in gradient can be used as an etch end-point signal.

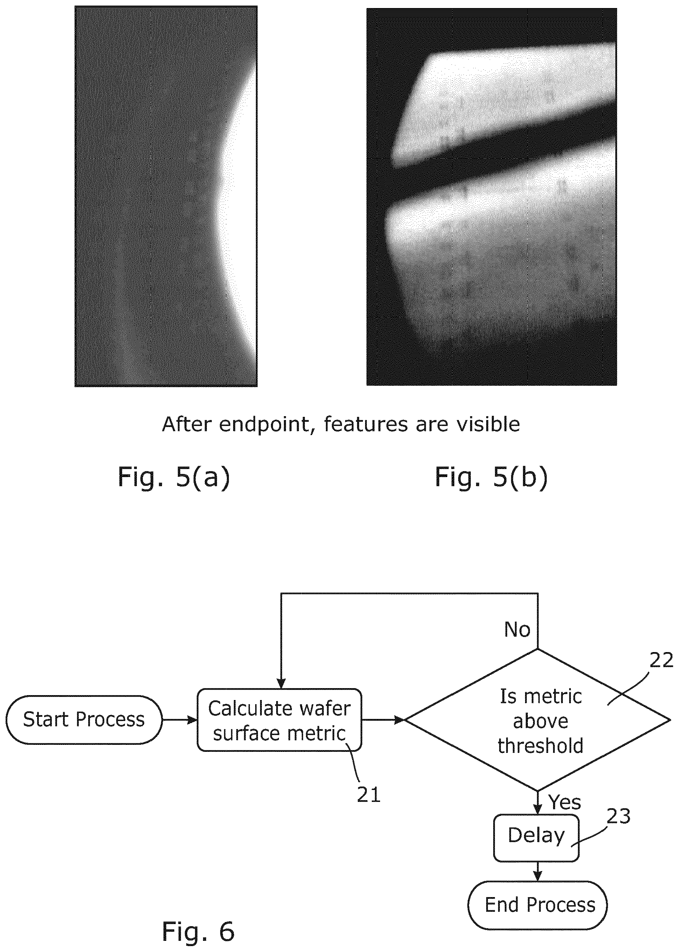

Figures 5(a) and (b) illustrate processed images where the light is scattered (i.e. the light source is opposite the camera) or reflected (i.e. the light source is transmitted from the same side as the camera). When the light is reflected, the features show brighter than the background as in Figure 5(a), whereas when it is scattered they are darker than the background as in Figure 5(b).

Positioning the camera at a shallow angle to the wafer means that the topography of the wafer is enhanced in the image relative to viewing directly from above. In a simplistic way one might see the slightly exposed tips 20 of the filled vias 19 as casting individual shadows. The more inclined the illumination, the greater the length of the shadow and the increased changed in the intensity gradient.

Figure 6 illustrates schematically the process. Thus the process is started and the camera is monitored as a function of time. The light incident on the camera passes through the Sobel filter 21 to produce an enhanced image. The output signal of the Sobel filter 24 is fed to a comparator 22. If the filter output is above a preset threshold then the comparator feeds a signal to a delay 23, which then either stops or modifies the process.

Components 22 and 23 will usually form part of the controller for the etch apparatus.

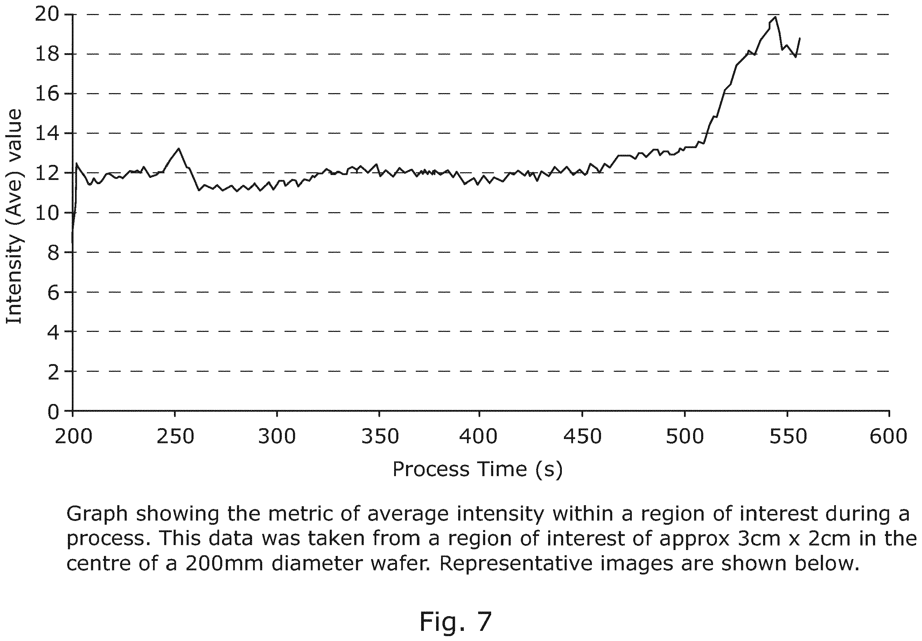

This method is further illustrated in Figure 7, which shows the average intensity of the camera output within a region of interest during the process. This sharp rise in average intensity after around 500 seconds illustrates the appearance of exposed vias.

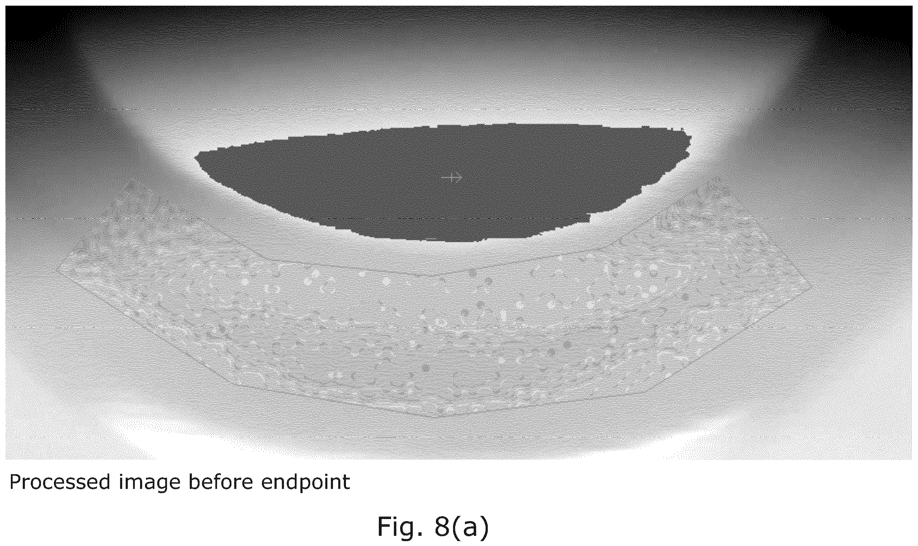

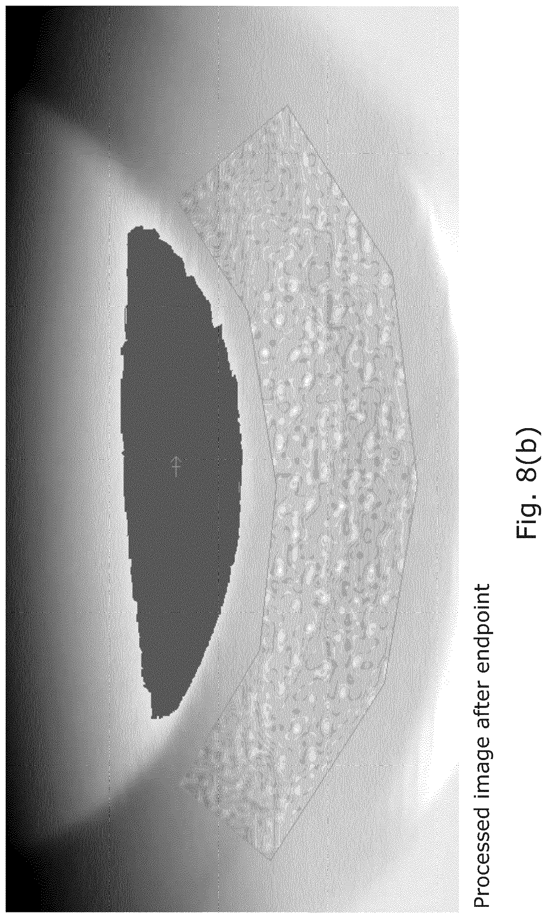

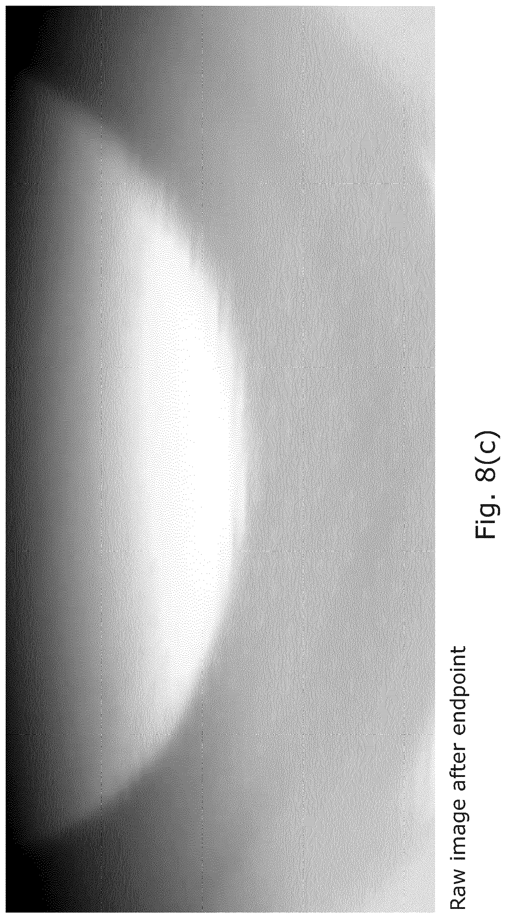

Further images are provided in Figure 8. Figure 8(a) shows a processed image before the end point; Figure 8(b) shows a processed image after the end point in which a series of aligned features, approximately 30° from the horizonal, can be readily detected and Figure 8(c) shows the corresponding raw image from which the processed image of Figure 8(b) has been prepared.

It will be understood that the Applicants' approach overcomes the loss of a reference surface and the lack of significant changes in plasma chemistry and, in the use of edge detectors, enables a particularly economic end point detection process and apparatus to be achieved.

## Claims

1. A method of etching the whole width of a substrate to expose the ends of features buried in the substrate including:
(a) etching a face of a substrate across its width to achieve substantially uniform removal of material;
(b) illuminating the etched face during the etch process;
(c) detecting non-homogeneity in an image of the face represented by light reflected or scattered from the face to detect the exposure of the buried features;
(d) modifying the etch in response to the detection of the buried features.

2. A method as claimed in claim 1, wherein step (c) includes applying edge detection techniques to light reflected or scattered from the face to detect the appearances of buried features;.

3. A method as claimed in claim 1 or claim 2, wherein the etched face is illustrated at an acute angle.

4. A method as claimed in any one of claims 1 to 3, wherein step (c) includes using a camera to capture the reflected or scattered light for producing an output signal and an edge detector filter for detecting the appearances of edges from the camera output signal.

5. A method as claimed in claim 4, wherein the camera is positioned for receiving light reflected or scattered at an acute angle.

6. A method as claimed in claim 4 or 5, wherein the edge detector filter is a Sobel filter.

7. A method as claimed in any one of the preceding claims wherein the step of modifying the etch is the step of stopping the etch.

8. Etching apparatus for etching substrate across its width to expose features buried in the substrate including:
(a) an etch chamber for etching a substrate
(b) a substrate comprising buried features;
(c) a support for a substrate for retaining the substrate in a generally horizontal position with a face to be etched exposed;
(d) an illumination source mounted at an acute angle with respect to the support for illuminating the face;
(e) a camera for computing light reflected or scattered from the face at an acute angle;
(f) an edge detector coupled to the camera for detecting the appearance of at least one edge on the face, and
(g) a controller for controlling the etch operation of the chamber and stopping the etch in response to the detection of an edge.

9. Apparatus as claimed in claim 8, wherein in the edge detector includes a Sobel filter.

## Patentansprüche

1. Verfahren zum Ätzen der gesamten Breite eines Substrats, um die Enden von Merkmalen freizulegen, die in dem Substrat vergraben sind, das Folgendes einschließt:
(a) Ätzen einer Fläche eines Substrats über seine Breite hinweg, um einen im Wesentlichen gleichmäßigen Materialabtrag zu erzielen;
(b) Beleuchten der geätzten Fläche während des Ätzvorgangs;
(c) Detektieren einer Inhomogenität in einem Bild der Fläche, die durch Licht dargestellt wird, das von der Fläche reflektiert oder gestreut wird, um die Freilegung der vergrabenen Merkmale zu detektieren;
(d) Modifizieren der Ätzung als Reaktion auf die Detektion der vergrabenen Merkmale.

2. Verfahren nach Anspruch 1, wobei Schritt (c) ein Anwenden von Kantendetektionstechniken auf Licht einschließt, das von der Fläche reflektiert oder gestreut wird, um das Auftreten von vergrabenen Merkmalen zu detektieren.

3. Verfahren nach Anspruch 1 oder 2, wobei die geätzte Fläche in einem spitzen Winkel veranschaulicht ist.

4. Verfahren nach einem der Ansprüche 1 bis 3, wobei Schritt (c) das Verwenden einer Kamera einschließt, um das reflektierte oder gestreute Licht zum Erzeugen eines Ausgangssignals und eines Kantendetektorfilters zum Detektieren des Auftretens von Kanten aus dem Kameraausgangssignal zu erfassen.

5. Verfahren nach Anspruch 4, wobei die Kamera zum Empfangen von Licht angeordnet ist, das in einem spitzen Winkel reflektiert oder gestreut wird.

6. Verfahren nach Anspruch 4 oder 5, wobei der Kantendetektorfilter ein Sobel-Filter ist.

7. Verfahren nach einem der vorhergehenden Ansprüche, wobei der Schritt des Modifizierens der Ätzung der Schritt des Stoppens der Ätzung ist.

8. Ätzeinrichtung zum Ätzen des Substrats über seine Breite hinweg, um Merkmale freizulegen, die in dem Substrat vergraben sind, die Folgendes einschließt:
(a) eine Ätzkammer zum Ätzen eines Substrats
(b) ein Substrat, das vergrabene Merkmale umfasst;
(c) einen Träger für ein Substrat zum Halten des Substrats in einer im Allgemeinen horizontalen Anordnung mit einer zu ätzenden Fläche, die freiliegt;
(d) eine Beleuchtungsquelle, die in einem spitzen Winkel in Bezug auf den Träger zum Beleuchten der Fläche angebracht ist;
(e) eine Kamera zum Berechnen von Licht, das in einem spitzen Winkel von der Fläche reflektiert oder gestreut wird;
(f) einen Kantendetektor, der mit der Kamera zum Detektieren des Auftretens von wenigstens einer Kante auf der Fläche gekoppelt ist, und
(g) eine Steuervorrichtung zum Steuern des Ätzablaufs der Kammer und zum Stoppen der Ätzung als Reaktion auf das Detektieren einer Kante.

9. Einrichtung nach Anspruch 8, wobei der Kantendetektor ein Sobel-Filter einschließt.

## Revendications

1. Procédé de gravure sur toute la largeur d'un substrat afin d'exposer les extrémités d'éléments enfouis dans le substrat comportant :
(a) la gravure d'une face d'un substrat sur sa largeur pour obtenir un enlèvement sensiblement uniforme de matière ;
(b) l'éclairage de la face gravée pendant le processus de gravure ;
(c) la détection de la non-homogénéité dans une image de la face représentée par la lumière réfléchie ou diffusée en provenance de la face afin de détecter l'exposition des éléments enfouis ;
(d) la modification de la gravure en réponse à la détection des éléments enfouis.

2. Procédé selon la revendication 1, dans lequel l'étape (c) comporte l'application de techniques de détection de bord à la lumière réfléchie ou diffusée en provenance de la face afin de détecter l'apparition d'éléments enfouis.

3. Procédé selon la revendication 1 ou la revendication 2, dans lequel la face gravée est illustrée à un angle aigu.

4. Procédé selon l'une quelconque des revendications 1 à 3, dans lequel l'étape (c) comporte l'utilisation d'un appareil photo pour capturer la lumière réfléchie ou diffusée dans le but de produire un signal de sortie et d'un filtre détecteur de bord afin de détecter l'apparition de bords à partir du signal de sortie d'appareil photo.

5. Procédé selon la revendication 4, dans lequel l'appareil photo est positionné de manière à recevoir la lumière réfléchie ou diffusée à un angle aigu.

6. Procédé selon la revendication 4 ou 5, dans lequel le filtre de détecteur de bord est un filtre de Sobel.

7. Procédé selon l'une quelconque des revendications précédentes, dans lequel l'étape de modification de la gravure est l'étape d'arrêt de la gravure.

8. Appareil de gravure destiné à graver un substrat sur sa largeur afin d'exposer des éléments enfouis dans le substrat comportant :
(a) une chambre de gravure destinée à graver un substrat
(b) un substrat comprenant des éléments enfouis ;
(c) un support pour un substrat destiné à retenir le substrat dans une position généralement horizontale avec une face à graver exposée ;
(d) une source d'éclairage montée à un angle aigu par rapport au support destinée à éclairer la face ;
(e) un appareil photo destiné à calculer la lumière réfléchie ou diffusée en provenance de la face à un angle aigu ;
(f) un détecteur de bord couplé à l'appareil photo destiné à détecter l'apparition d'au moins un bord sur la face, et
(g) un dispositif de commande destiné à commander l'opération de gravure de la chambre et à arrêter la gravure en réponse à la détection d'un bord.

9. Appareil selon la revendication 8, dans lequel le détecteur de bord comporte un filtre de Sobel.
